# EUROPEAN PATENT SPECIFICATION

(11) **EP 3 621 105 B1**
(45) Date of publication and mention of the grant of the patent: **10.12.2025**
(21) Application number: 17908502.2
(22) Date of filing: 27.05.2017
(51) Int. Cl.: H10K 59/12, H10D 30/67, H10D 86/40, H10D 86/60

(54) **OLED DISPLAY PANEL AND METHOD FOR MANUFACTURING SAME**
OLED-ANZEIGETAFEL UND VERFAHREN ZU IHRER HERSTELLUNG
PANNEAU D'AFFICHAGE OLED ET SON PROCÉDÉ DE FABRICATION

(30) Priority: 02.05.2017 CN 201710302087
(43) Date of publication of application: 11.03.2020
(73) Proprietor: Shenzhen China Star Optoelectronics Technology Co., Ltd., Shenzhen, Guangdong 518132 (CN)
(72) Inventor: ZHANG, Xiaoxing, Shenzhen Guangdong 518132 (CN); HSU, Yuan-jun, Shenzhen Guangdong 518132 (CN)
(74) Representative: Keil & Schaafhausen Patentanwälte PartGmbB
(86) International application number: PCT/CN2017/086234
(87) International publication number: WO 2018/201542

(56) References cited:
- WO-A1-2016/009715
- WO-A2-2009/136645
- CN-A- 101 086 998
- CN-A- 101 373 792
- CN-A- 102 376 896
- CN-A- 103 887 324
- CN-A- 104 576 682
- US-A1- 2010 136 722
- US-A1- 2013 020 321
- US-A1- 2015 097 179
- US-A1- 2016 005 873

## Description

### Field of the Invention

The present invention relates to a technology of display, and more particularly, to an organic light-emitting display panel and a manufacturing method thereof.

### Description of Prior Art

Currently, because oxide semiconductor thin film transistor (TFT)with the top gate structure has a smaller parasitic capacitance, the size of TFT can be smaller to be a better choice for organic light-emitting display (OLED) drive. However, the oxide semiconductor in contact with a source and a drain, need to be processed to be converted into conductor in the manufacturing process of the oxide semiconductor TFT with the top gate structure, thereby the contact impedance of the source and the drain is reduced, and the switching function of the TFT is achieved.

In the prior art, to convert the oxide semiconductor in contact with the source and the drain into a conductor, is generally processed by hydrogen plasma or argon plasma. However, because the OLED display panel has another annealing process after arranging the TFT, the annealing processes will make the conductive oxide to be converted back into semiconductor, so that the contact impedance of the source and the drain will become larger, the TFT characteristics is reduced, and even the TFT losses its switching function. US 2016/005873 A1, WO 2009/136645 A2, and US 2015/097179 A1 are related prior art for this field.

### Summary of the Invention

The present invention is mainly to provide an OLED display panel and a manufacturing method thereof, to solve the problem that the contact impedance of source and drain become larger because a part of oxide semiconductor with conductor characteristics is converted into back to semiconductor in the OLED display panel manufacturing process.

In order to solve the above-mentioned technical problem, a technical solution adopted by the present invention is providing a manufacturing method as defined in claim 1.

In order to solve the above-mentioned technical problem, a further technical solution adopted by the present invention is providing an organic light-emitting diode display panel as defined in claim 8.

The present invention can be concluded with the following advantages, the present invention is different from the prior art of a buffer layer deposited on a substrate and an oxide semiconductor pattern layer, a gate insulating layer, and a gate pattern layer are stacked sequentially on the buffer layer; arranging a dielectric layer for covering the oxide semiconductor pattern layer, the gate insulating layer, and the gate pattern layer on the buffer layer, and the dielectric layer comprises a silicon nitride layer in contact with the oxide semiconductor pattern layer; annealing the dielectric layer, and the silicon nitride layer making a part of oxide semiconductor pattern layer to have conductor characteristics during the annealing process; a method of arranging a source and a drain are in contact with the part of oxide semiconductor pattern layer, with conductor characteristics, wherein the method is to use the feature that silicon nitride has more hydrogen atoms, so that the oxide semiconductor in contact with the part of oxide semiconductor pattern layer with conductor characteristics, can be continuously doped with hydrogen atoms to hold conductor characteristics, and the contact impedance between the part of oxide semiconductor pattern layer and the source and the drain can be continuously maintained at a low state to achieve the function of TFT.

### Brief Description of Drawings

Figure 1 is a flow chart of method of manufacturing an organic light-emitting diode display panel of an embodiment in the present invention;
Figure 2 is a structural illustration of an embodiment made in accordance to an organic light-emitting diode display panel in the present invention;
Figure 3 is a specific flow chart of step S11 in Fig. 1; and
Figure 4 is a specific flow chart of step S14 in Fig. 1.

### Description of Preferred Embodiment

Technical implementation will be described below clearly and fully by combining with drawings made in accordance with an embodiment in the present invention.

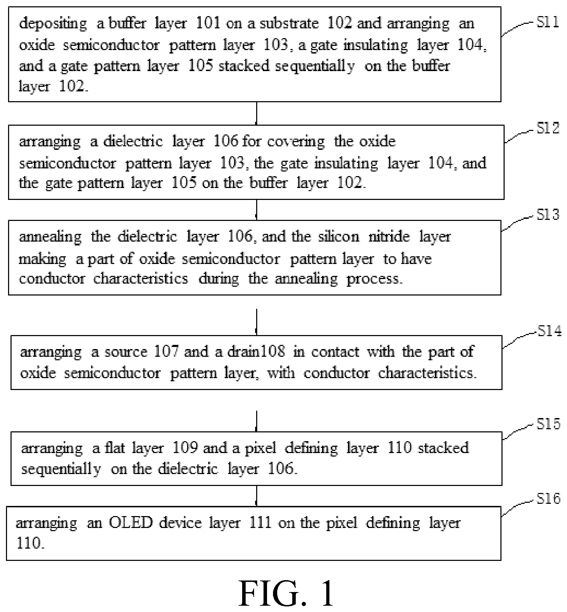

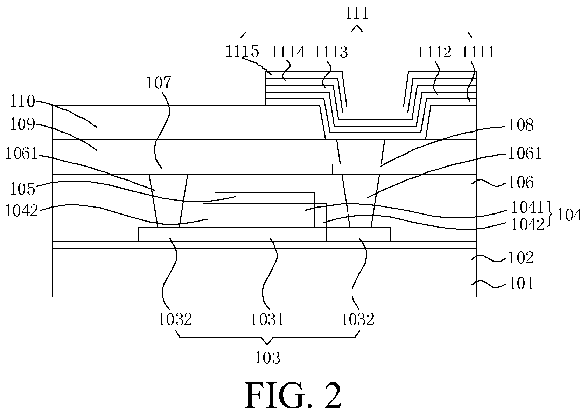

Referring to Fig. 1 and Fig. 2, the method of manufacturing an organic light-emitting diode display panel of the present invention, which comprises:
S11: depositing a buffer layer 102 on a substrate 101 and arranging an oxide semiconductor pattern layer 103, a gate insulating layer 104, and a gate pattern layer 105 stacked sequentially on the buffer layer 102.

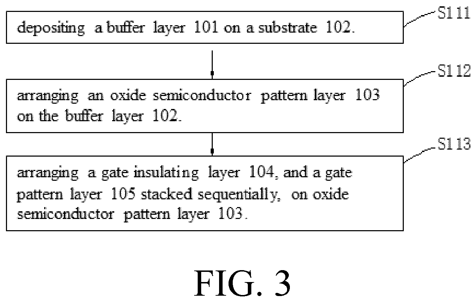

Referring to Fig. 3, the step S11 may specifically include:
S111: depositing a buffer layer 102 on a substrate 101.

Specifically, before depositing the buffer layer 102, cleaning the substrate 101,then the buffer layer 102 may be deposited on the substrate 101 by physical vapor deposition method or plasma vapor deposition method, wherein it may deposit a silicon oxide layer on the substrate 101 as a buffer layer 102, or it may be also to deposit a silicon nitride layer on the substrate 101 first, and then depositing a silicon oxide layer with a thickness of not less than 3000 Å on the silicon nitride layer, so that the silicon nitride layer and the silicon oxide layer form a buffer layer 102 collectively.

Wherein the substrate 101 may be a glass substrate, or a silicon substrate, including, but not limited to.

S112: arranging an oxide semiconductor pattern layer 103 on the buffer layer 102.

Specifically, arranging an oxide semiconductor pattern layer 103 on the silicon oxide layer on the buffer layer 102,it may deposit an oxide semiconductor with a thickness of 400 to 600 Å on the silicon oxide layer in the buffer layer 102,and then processing photoresist coating, exposure, development, and peeling of the photolithography process to form an oxide semiconductor pattern layer, because the silicon oxide does not contain hydrogen atoms, in this step S112, the oxide semiconductor pattern layer is not converted into conductor.

Wherein the oxide semiconductor pattern layer 103 comprises a first part 1031 and a second part 1032, the second part 1032 is adjacent to the first part 1031. In the figure of the present embodiment, the second part 1032 is located on opposite sides of the first part 1031.

Preferably, the oxide semiconductor is indium gallium zinc oxide (IGZO.)

S113: arranging a gate insulating layer 104, and a gate pattern layer 105 stacked sequentially, on oxide semiconductor pattern layer 103.

Wherein the gate insulating layer 104 is arranged opposite to the first part 1031 of the oxide semiconductor pattern layer 103, the gate insulating layer 104 comprises a third part 1041 and a fourth part 1042, the fourth part 1042 is adjacent to the third part 1041. In the figure of the present embodiment, the fourth part 1042 is located on opposite sides of the third part 1041 and the third part 1041 is arranged opposite to the gate pattern layer 105.

Specifically, it may use the physical vapor deposition method or plasma vapor deposition method to deposit a silicon oxide layer with a thickness of 1000 to 2000 Å on the buffer layer 102,and the silicon oxide layer covers the oxide semiconductor pattern layer 103,and then depositing a metal layer on the silicon oxide layer, after photoresist coating, exposure, and development, etching the metal layer and the silicon oxide layer simultaneously, to form the gate pattern layer 105 and the gate insulating layer 104. During the etching process, as shown in Fig. 2, suitable etching conditions make that the opposite sides of the gate insulating layer 104 extends beyond the gate pattern layer 105. The parts of the opposite sides of the gate insulating layer extending beyond the gate pattern layer are the fourth part 1042, and the part in the middle, arranging opposite to the gate pattern layer 105 is the third part 1041.

Wherein the metal layer is molybdenum, aluminum or copper metal layer, including, but not limited to.

According to the claimed invention, the length of the fourth part 1042 is 0.3µm to 1µm.

In other embodiments, the gate insulating layer 104 and the gate pattern layer 105 may be formed in two steps, respectively. It may deposit the silicon oxide layer on the buffer layer 102 first, processing photoresist coating, exposure, development, etching, and peeling, to form the gate insulating layer 104 arranged opposite to the oxide semiconductor pattern layer 103. Then depositing metal layer on the gate insulating layer 104, processing photoresist coating, exposure, development, etching, and peeling again, to form the gate pattern layer 105, and make that the gate pattern layer 105 is arranged opposite to the third part 1041 of the gate insulating layer 104.

S12: arranging a dielectric layer 106 for covering the oxide semiconductor pattern layer 103, the gate insulating layer 104, and the gate pattern layer 105 on the buffer layer 102.

Wherein the dielectric layer 106 comprises a silicon nitride layer in contact with the oxide semiconductor pattern layer 103.

Specifically, it may use the physical vapor deposition method or plasma vapor deposition method to deposit a silicon nitride layer with a thickness of 4000 to 5000 Å on the buffer layer 102 to form the dielectric layer 106, or it may deposit a silicon nitride layer with a thickness of 3000 Å on the buffer layer 102, and then deposit a silicon oxide layer with a thickness of 3000 Å, so that the silicon nitride layer and the silicon oxide layer form a dielectric layer 106 collectively. It should be notice that by the above-mentioned steps, the thickness of the silicon nitride layer in the dielectric layer 106 is larger than the thickness of the oxide semiconductor pattern layer 103 and the thickness of the gate insulating layer 104, so that the dielectric layer 106 can contact the second part 1032 of the oxide semiconductor pattern layer 103 and the fourth part 1042 of the gate insulating layer 104.

S13: annealing the dielectric layer 106, and the silicon nitride layer making a part of oxide semiconductor pattern layer to have conductor characteristics during the annealing process.

Specifically, because the silicon nitride layer contains hydrogen atoms, during the annealing process of the dielectric layer 106, under high temperature, the hydrogen atoms are diffused to the oxide semiconductor pattern layer 103 where in the bottom as shown in Fig. 2. During the diffusion process, because the second part 1032 of the oxide semiconductor pattern layer 103 is in contact with the silicon nitride layer, the hydrogen atoms diffuse to the second part 1032 so that the second part 1032 is doped with hydrogen atoms to have conductor characteristics.

Wherein, because the gate insulating layer 104 is a silicon oxide layer, the first part 1031 arranged opposite the gate insulating layer 104 is protected by the gate insulating layer 104, to prevent the diffusion of hydrogen atoms into the first part 1031, so that after the annealing, the first part 1031 still holds semiconductor characteristics. And according to the above-described step S113, the gate insulating layer 104 is larger in size on the cross-section than the gate pattern layer 105, to further prevent the hydrogen atoms in the silicon nitride layer from diffusing down to the first part 1031,so that the first part 1031 still holds semiconductor characteristics.

S14: arranging a source 107 and a drain 108 in contact with the part of oxide semiconductor pattern layer, with conductor characteristics.

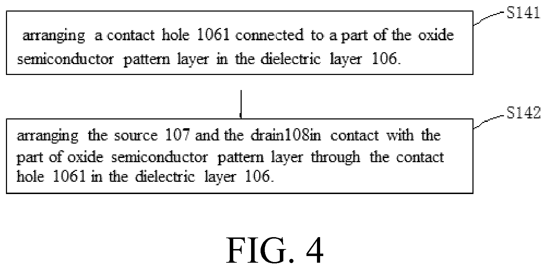

Referring to Fig. 4, the step S14 may specifically include:
S141: arranging a contact hole 1061 connected to a part of the oxide semiconductor pattern layer in the dielectric layer 106.

Specifically, a patterned contact hole may be formed by photoresist coating and exposure, then processed dry etching, the contact hole 1061 may be obtained after removal.

Wherein both the dielectric layer 106 and the second part 1032 on both sides of the oxide semiconductor pattern layer 103, have a contact hole 1061.

S142: arranging the source 107 and the drain108in contact with the part of oxide semiconductor pattern layer through the contact hole 1061 in the dielectric layer 106.

Specifically, it may deposit metal on the dielectric layer 106 and the contact hole 1061 to form a metal layer by physical vapor deposition method, then depositing a photoresist layer on the deposited metal layer, and processing exposure, development, etching, and peeling, to form a patterned source 107 and drain 108. Because the contact hole 1061 is connected to the second part 1032 of the oxide semiconductor pattern layer 103, so that the patterned source 107 and the drain 108 are in contact with the second part 1032 of the oxide semiconductor pattern layer 103.

Further, the present embodiment further comprises:
S15: arranging a flat layer 109 and a pixel defining layer 110 stacked sequentially on the dielectric layer 106.
   Specifically, it may deposit a silicon nitride layer or a silicon oxide layer on the dielectric layer 106 by physical vapor deposition method or a plasma vapor deposition method, to form the flat layer 109, then depositing a silicon nitride layer or a silicon oxide layer on the flat layer 109, and processing exposure, development, and, etching, to form a pixel light emitting region. The silicon nitride layer or the silicon oxide layer with the pixel light emitting region is the pixel defining layer 110.
S16: arranging an OLED device layer 111 on the pixel defining layer 110.

Specifically, arranging sequentially an anode layer 1111, an electron transport layer 1112, a light emitting layer 1113, a hole transport layer 1114, and a cathode layer 1115 at the position opposite to the pixel light emitting region on the pixel definition layer 110.

Further, referring to Fig. 2, the OLED display panel of the embodiment of the present invention, which comprises a buffer layer 102 deposited on a substrate 101; an oxide semiconductor pattern layer 103, a gate insulating layer 104, and a gate pattern layer 105 stacked sequentially on the buffer layer 102; a dielectric layer 106 covers the oxide semiconductor pattern layer 103, the gate insulating layer 104, and the gate pattern layer 105; and a source 107 and a drain108 are in contact with the oxide semiconductor pattern layer 103.

Wherein the oxide semiconductor pattern layer 103 comprises a first part 1031 and a second part 1032, the second part 1032 is adjacent to the first part 1031, the first part 1031 is arranged opposite to the gate insulating layer 104, the second part 1032 has conductor characteristics.

Specifically, the dielectric layer 106 comprises a silicon nitride layer in contact with the oxide semiconductor pattern layer 103. Because the silicon nitride layer contains hydrogen atoms, during the manufacturing process, the hydrogen atoms in the silicon nitride layer diffuse to the oxide semiconductor pattern layer 103, so as the second part 1032 in contact with the silicon nitride layer, is doped with the hydrogen atoms, thereby the second part 1032 has conductor characteristics. The first part 1031 is arrange opposite to the gate insulating layer 104 and is protected by the gate insulating layer 104 to prevent the first part 1031 from doping the hydrogen atoms, so that the first part 1031 still holds semiconductor characteristics.

Further, the display panel of the present embodiment further comprises a flat layer 109, a pixel defining layer 110, and an OLED device layer 111 stacked sequentially on the dielectric layer 106.

Each of the layers in the present embodiment can be manufactured by the steps corresponding to the above-described methods, therefore no additional description is given here below.

The present invention is different from the prior art of a buffer layer deposited on a substrate and an oxide semiconductor pattern layer, a gate insulating layer, and a gate pattern layer are stacked sequentially on the buffer layer; arranging a dielectric layer for covering the oxide semiconductor pattern layer, the gate insulating layer, and the gate pattern layer on the buffer layer, and the dielectric layer comprises a silicon nitride layer in contact with the oxide semiconductor pattern layer; annealing the dielectric layer, and the silicon nitride layer making a part of oxide semiconductor pattern layer to have conductor characteristics during the annealing process; a method of arranging a source and a drain are in contact with the part of oxide semiconductor pattern layer, with conductor characteristics, wherein the method is to use the feature that silicon nitride has more hydrogen, so that the oxide semiconductor in contact with the part of oxide semiconductor pattern layer with conductor characteristics, can be continuously doped with hydrogen to hold conductor characteristics, and the contact impedance between the part of oxide semiconductor pattern layer and the source and the drain can be continuously maintained at a low state to achieve the function of TFT.

Embodiments of the present invention have been described, but not intending to impose any unduly constraint to the appended claims.

## Claims

1. A method of manufacturing an organic light-emitting diode display panel, wherein the method comprises:
depositing a buffer layer (102) on a substrate (101) and arranging an oxide semiconductor pattern layer (103), a gate insulating layer (104), and a gate pattern layer (105) stacked sequentially on the buffer layer (102);
arranging a dielectric layer (106) for covering the oxide semiconductor pattern layer (103), the gate insulating layer (104), and the gate pattern layer (105) on the buffer layer (102), and the dielectric layer (106) comprising a silicon nitride layer in contact with the oxide semiconductor pattern layer (103);
annealing the dielectric layer (106), and the silicon nitride layer making a part of the oxide semiconductor pattern layer (103) have conductor characteristics during the annealing process; and
arranging a source (107) and a drain (108) to be in contact with the part of the oxide semiconductor pattern layer (103) having the conductor characteristics;
**characterized in that** two opposite sides of the gate insulating layer (104) extend beyond the gate pattern layer (105) to have a length of extended parts ranging from 0.3µm to 1µm, and a thickness of the gate insulating layer (104) is uniform;
wherein the method further comprises:
arranging a flat layer (109) and a pixel defining layer (110) stacked sequentially on the dielectric layer (106); and
arranging sequentially an anode layer (1111), an electron transport layer (1112), a light emitting layer (1113), a hole transport layer (1114), and a cathode layer (1115) at a position opposite to a pixel light emitting region on the pixel definition layer (110).

2. The method as recited in claim 1, **characterized in that** the oxide semiconductor pattern layer (103) comprises a first part (1031) and a second part (1032), the second part (1032) is adjacent to the first part (1031), the first part (1031) is arranged opposite to the gate insulating layer (104), the second part (1032) is in contact with the silicon nitride layer, and the process of annealing the dielectric layer (106), and the silicon nitride layer making the part of the oxide semiconductor pattern layer (103) have the conductor characteristics during the annealing process comprises:
annealing the dielectric layer (106), and the silicon nitride layer making the second part (1032) be in contact with the silicon nitride layer to have the conductor characteristics during the annealing process.

3. The method as recited in claim 2, **characterized in that** the silicon nitride layer contains hydrogen atoms, and the process of annealing the dielectric layer (106), and the silicon nitride layer making the second part (1032) be in contact with the silicon nitride layer to have the conductor characteristics during the annealing process comprises:
during the annealing process, the hydrogen atoms in the silicon nitride layer diffusing to the oxide semiconductor pattern layer (103) to allow the second part (1032) to be in contact with the silicon nitride layer and to be doped with the hydrogen atoms to have the conductor characteristics.

4. The method as recited in claim 3, **characterized in that** the gate insulating layer (104) is a silicon oxide layer, the gate insulating layer (104) and the first part (1031) arranged opposite to the gate insulating layer (104) hold semiconductor characteristics after annealing.

5. The method as recited in claim 1, **characterized in that** the buffer layer (102) comprises a silicon oxide layer in contact with the oxide semiconductor pattern layer (103);

6. The method as recited in claim 2, **characterized in that** the gate insulating layer (104) comprises a third part (1041) and a fourth part (1042), the fourth part (1042) is adjacent to the third part (1041), the third part (1041) is arranged opposite to the gate pattern layer (105), and the fourth part (1042) is in contact with the silicon nitride layer.

7. The method as recited in claim 1, **characterized in that** the process of arranging the source (107) and the drain (108) to be in contact with the part of the oxide semiconductor pattern layer (103) having the conductor characteristics comprises:
arranging a contact hole (1061) connected to the part of the oxide semiconductor pattern layer (103) in the dielectric layer (106);
arranging the source (107) and the drain (108) to be in contact with the part of the oxide semiconductor pattern layer (103) through the contact hole (1061) in the dielectric layer (106).

8. An organic light-emitting diode display panel, wherein the display panel comprises:
a substrate (101);
a buffer layer (102) deposited on the substrate (101);
an oxide semiconductor pattern layer (103), a gate insulating layer (104), and a gate pattern layer (105) stacked sequentially on the buffer layer (102), wherein a part of the oxide semiconductor pattern layer (103) has conductor characteristics;
a dielectric layer (106) covering the oxide semiconductor pattern layer (103), the gate insulating layer (104), and the gate pattern layer (105), and the dielectric layer (106) comprising a silicon nitride layer in contact with the oxide semiconductor pattern layer (103); and
a source (107) and a drain (108) in contact with the part of the oxide semiconductor pattern layer (103) having the conductor characteristics;
**characterized in that** two opposite sides of the gate insulating layer (104) extend beyond the gate pattern layer (105) to have a length of extended parts ranging from 0.3µm to 1µm, and a thickness of the gate insulating layer (104) is uniform;
wherein the display panel further comprises:
a flat layer (109) and a pixel defining layer (110) stacked sequentially on the dielectric layer (106); and
an anode layer (1111), an electron transport layer (1112), a light emitting layer (1113), a hole transport layer (1114), and a cathode layer (1115) arranged sequentially at a position opposite to a pixel light emitting region on the pixel definition layer (110).

9. The display panel as recited in claim 8, **characterized in that** the oxide semiconductor pattern layer (103) comprises a first part (1031) and a second part (1032), the second part (1032) is adjacent to the first part (1031), the first part (1031) is arranged opposite to the gate insulating layer (104), the second part (1032) is in contact with the silicon nitride layer to have the conductor characteristics.

10. The display panel as recited in claim 9, **characterized in that** the silicon nitride layer contains hydrogen atoms, during the manufacturing process, the hydrogen atoms in the silicon nitride layer diffuse to the oxide semiconductor pattern layer (103) to allow the second part (1032) to be in contact with the silicon nitride layer and to be doped with the hydrogen atoms to have the conductor characteristics.

## Patentansprüche

1. Verfahren zur Herstellung eines organischen Leuchtdioden-Anzeigepanels, wobei das Verfahren Folgendes umfasst:
Abscheiden einer Pufferschicht (102) auf einem Substrat (101) und Anordnen einer Oxid-Halbleitermusters-Schicht (103), einer Gate-Isolierschicht (104) und einer Gate-Musters-Schicht (105), die auf der Pufferschicht (102) nacheinander gestapelt sind;
Anordnen einer dielektrischen Schicht (106), um die Oxid-Halbleitermusters-Schicht (103), die Gate-Isolierschicht (104) und die Gate-Musters-Schicht (105) auf der Pufferschicht (102) abzudecken, wobei die dielektrische Schicht (106) eine Siliziumnitridschicht umfasst, die mit der Oxid-Halbleitermusters-Schicht (103) in Kontakt steht;
Tempern der dielektrischen Schicht (106), wobei die Siliziumnitridschicht während des Tempervorgangs einen Teil der Oxid-Halbleitermusters-Schicht (103) leitfähige Eigenschaften erhalten lässt; und
Anordnen einer Quelle (107) und einer Drain-Elektrode (108), die mit dem Teil der Oxid-Halbleitermusters-Schicht (103) mit den leitfähigen Eigenschaften in Kontakt stehen;
**dadurch gekennzeichnet, dass**
zwei gegenüberliegende Seiten der Gate-Isolierschicht (104) über die Gate-Musters-Schicht (105) hinausragen, sodass die Länge der verlängerten Teile zwischen 0,3 µm und 1 µm liegt, und die Dicke der Gate-Isolierschicht (104) gleichmäßig ist;
wobei das Verfahren ferner Folgendes umfasst:
Anordnen einer Planschicht (109) und einer Pixel-Definitionsschicht (110), die nacheinander auf der dielektrischen Schicht (106) gestapelt sind; und
nacheinander Anordnen einer Anodenschicht (1111), einer Elektronentransportschicht (1112), einer lichtemittierenden Schicht (1113), einer Lochtransportschicht (1114) und einer Kathodenschicht (1115) an einer Position gegenüber einem Pixel-Lichtemissionsbereich auf der Pixel-Definitionsschicht (110).

2. Verfahren nach Anspruch 1, **dadurch gekennzeichnet, dass** die Oxid-Halbleitermusters-Schicht (103) einen ersten Teil (1031) und einen zweiten Teil (1032) umfasst, wobei der zweite Teil (1032) an den ersten Teil (1031) angrenzt, der erste Teil (1031) der Gate-Isolierschicht (104) gegenüber angeordnet ist, der zweite Teil (1032) mit der Siliziumnitridschicht in Kontakt steht, und der Prozess des Temperns der dielektrischen Schicht (106) sowie der Siliziumnitridschicht, wodurch der Teil der Oxid-Halbleitermusters-Schicht (103) während des Tempervorgangs leitfähige Eigenschaften erhält, Folgendes umfasst:
Tempern der dielektrischen Schicht (106), wobei die Siliziumnitridschicht den zweiten Teil (1032), der mit der Siliziumnitridschicht in Kontakt steht, während des Tempervorgangs leitfähige Eigenschaften erhalten lässt.

3. Verfahren nach Anspruch 2, **dadurch gekennzeichnet, dass** die Siliziumnitridschicht Wasserstoffatome enthält und der Prozess des Temperns der dielektrischen Schicht (106) sowie der Siliziumnitridschicht, wodurch der zweite Teil (1032), der mit der Siliziumnitridschicht in Kontakt steht, während des Tempervorgangs leitfähige Eigenschaften erhält, Folgendes umfasst:
während des Tempervorgangs diffundieren die Wasserstoffatome aus der Siliziumnitridschicht in die Oxid-Halbleitermusters-Schicht (103), sodass der zweite Teil (1032), der mit der Siliziumnitridschicht in Kontakt steht, mit den Wasserstoffatomen dotiert wird und leitfähige Eigenschaften erhält.

4. Verfahren nach Anspruch 3, **dadurch gekennzeichnet, dass** die Gate-Isolierschicht (104) eine Siliziumoxidschicht ist, wobei die Gate-Isolierschicht (104) und der erste Teil (1031), der der Gate-Isolierschicht (104) gegenüber angeordnet ist, nach dem Tempern Halbleitereigenschaften beibehalten.

5. Verfahren nach Anspruch 1, **dadurch gekennzeichnet, dass** die Pufferschicht (102) eine Siliziumoxidschicht umfasst, die mit der Oxid-Halbleitermusters-Schicht (103) in Kontakt steht.

6. Verfahren nach Anspruch 2, **dadurch gekennzeichnet, dass** die Gate-Isolierschicht (104) einen dritten Teil (1041) und einen vierten Teil (1042) umfasst, wobei der vierte Teil (1042) an den dritten Teil (1041) angrenzt, der dritte Teil (1041) der Gate-Musters-Schicht (105) gegenüber angeordnet ist und der vierte Teil (1042) mit der Siliziumnitridschicht in Kontakt steht.

7. Verfahren nach Anspruch 1, **dadurch gekennzeichnet, dass** der Prozess des Anordnens der Quelle (107) und der Drain-Elektrode (108), die mit dem Teil der Oxid-Halbleitermusters-Schicht (103) mit den leitfähigen Eigenschaften in Kontakt stehen, Folgendes umfasst:
Anordnen eines Kontaktlochs (1061), das mit dem Teil der Oxid-Halbleitermusters-Schicht (103) in der dielektrischen Schicht (106) verbunden ist;
Anordnen der Quelle (107) und der Drain-Elektrode (108), um durch das Kontaktloch (1061) in der dielektrischen Schicht (106) mit dem Teil der Oxid-Halbleitermusters-Schicht (103) in Kontakt zu stehen.

8. Organisches Leuchtdioden-Anzeigepanel, wobei das Anzeigepanel Folgendes umfasst:
ein Substrat (101);
eine Pufferschicht (102), die auf dem Substrat (101) abgeschieden ist;
eine Oxid-Halbleitermusters-Schicht (103), eine Gate-Isolierschicht (104) und eine Gate-Musters-Schicht (105), die nacheinander auf der Pufferschicht (102) gestapelt sind, wobei ein Teil der Oxid-Halbleitermusters-Schicht (103) leitfähige Eigenschaften erhält;
eine dielektrische Schicht (106), die die Oxid-Halbleitermusters-Schicht (103), die Gate-Isolierschicht (104) und die Gate-Musters-Schicht (105) abdeckt, wobei die dielektrische Schicht (106) eine Siliziumnitridschicht umfasst, die mit der Oxid-Halbleitermusters-Schicht (103) in Kontakt steht; und
eine Quelle (107) und eine Drain-Elektrode (108), die mit dem Teil der Oxid-Halbleitermusters-Schicht (103) mit den leitfähigen Eigenschaften in Kontakt stehen;
**dadurch gekennzeichnet, dass**
zwei gegenüberliegende Seiten der Gate-Isolierschicht (104) ragen über die Gate-Musters-Schicht (105) hinaus, sodass die Länge der verlängerten Teile zwischen 0,3 µm und 1 µm liegt, und die Dicke der Gate-Isolierschicht (104) gleichmäßig ist;
wobei das Anzeigepanel ferner Folgendes umfasst:
eine Planschicht (109) und eine Pixel-Definitionsschicht (110), die nacheinander auf der dielektrischen Schicht (106) gestapelt sind; und
eine Anodenschicht (1111), eine Elektronentransportschicht (1112), eine lichtemittierende Schicht (1113), eine Lochtransportschicht (1114) und eine Kathodenschicht (1115), die nacheinander an einer Position gegenüber einem Pixel-Lichtemissionsbereich auf der Pixel-Definitionsschicht (110) angeordnet sind.

9. Anzeigepanel nach Anspruch 8, **dadurch gekennzeichnet, dass** die Oxid-Halbleitermusters-Schicht (103) einen ersten Teil (1031) und einen zweiten Teil (1032) umfasst, wobei der zweite Teil (1032) an den ersten Teil (1031) angrenzt, der erste Teil (1031) der Gate-Isolierschicht (104) gegenüber angeordnet ist und der zweite Teil (1032) mit der Siliziumnitridschicht in Kontakt steht, um leitfähige Eigenschaften zu erhalten.

10. Anzeigepanel nach Anspruch 9, **dadurch gekennzeichnet, dass** die Siliziumnitridschicht Wasserstoffatome enthält, wobei während des Herstellungsprozesses die Wasserstoffatome in der Siliziumnitridschicht in die Oxid-Halbleitermusters-Schicht (103) diffundieren, sodass der zweite Teil (1032), der mit der Siliziumnitridschicht in Kontakt steht, mit den Wasserstoffatomen dotiert wird und leitfähige Eigenschaften erhält.

## Revendications

1. Procédé de fabrication d'un panneau d'affichage à diode électroluminescente organique, dans lequel le procédé comprend :
déposer une couche tampon (102) sur un substrat (101) et disposer une couche semi-conductrice à oxyde à motif (103), une couche de grille isolante (104) et une couche de grille à motif (105) empilées successivement sur la couche tampon (102) ;
disposer une couche diélectrique (106) pour recouvrir la couche semi-conductrice à oxyde à motif (103), la couche de grille isolante (104) et la couche de grille à motif (105) sur la couche tampon (102), la couche diélectrique (106) comprenant une couche de nitrure de silicium en contact avec la couche semi-conductrice à oxyde à motif (103) ;
recuire la couche diélectrique (106), la couche de nitrure de silicium amenant une partie de la couche semi-conductrice à oxyde à motif (103) à présenter des caractéristiques de conducteur pendant le processus de recuit ; et
disposer une source (107) et un drain (108) pour être en contact avec la partie de la couche semi-conductrice à oxyde à motif (103) présentent les caractéristiques de conducteur ;
**caractérisé en ce que**,
deux côtés opposés de la couche de grille isolante (104) s'étendent au-delà de la couche de grille à motif (105) pour présenter une longueur de parties étendues comprise entre 0,3 µm et 1 µm, et une épaisseur de la couche de grille isolante (104) est uniforme ;
dans lequel le procédé comprend en outre :
disposer une couche plane (109) et une couche de définition de pixels (110) empilées successivement sur la couche diélectrique (106) ; et
disposer successivement une couche d'anode (1111), une couche de transfert d'électrons (1112), une couche lumineuse (1113), une couche de transfert de trous (1114) et une couche de cathode (1115) à une position à l'opposé d'une région lumineuse de pixels sur la couche de définition de pixels (110).

2. Procédé selon la revendication 1, **caractérisé en ce que** la couche semi-conductrice à oxyde à motif (103) comprend une première partie (1031) et une deuxième partie (1032), la deuxième partie (1032) étant adjacente à la première partie (1031), la première partie (1031) étant disposée à l'opposé de la couche de grille isolante (104), la deuxième partie (1032) étant en contact avec la couche de nitrure de silicium, et le processus de recuire la couche diélectrique (106), la couche de nitrure de silicium amenant la partie de la couche semi-conductrice à oxyde à motif (103) à présenter des caractéristiques de conducteur pendant le processus de recuit, comprenant :
recuire la couche diélectrique (106), la couche de nitrure de silicium amenant la deuxième partie (1032) à être en contact avec la couche de nitrure de silicium pour présenter des caractéristiques de conducteur pendant le processus de recuit.

3. Procédé selon la revendication 2, **caractérisé en ce que** la couche de nitrure de silicium contient des atomes d'hydrogène, et le processus de recuire la couche diélectrique (106), la couche de nitrure de silicium amenant la deuxième partie (1032) à être en contact avec la couche de nitrure de silicium pour présenter des caractéristiques de conducteur pendant le processus de recuit, comprend :
pendant le processus de recuit, les atomes d'hydrogène dans la couche de nitrure de silicium se diffusant vers la couche semi-conductrice à oxyde à motif (103) pour permettre à la deuxième partie (1032) d'être en contact avec la couche de nitrure de silicium et d'être dopée des atomes d'hydrogène pour présenter les caractéristiques de conducteur.

4. Procédé selon la revendication 3, **caractérisé en ce que** la couche de grille isolante (104) est une couche d'oxyde de silicium, et la couche de grille isolante (104) et la première partie (1031) disposées à l'opposé de la couche de grille isolante (104) conservent des caractéristiques semi-conductrices après le recuit.

5. Procédé selon la revendication 1, **caractérisé en ce que** la couche tampon (102) comprend une couche d'oxyde de silicium en contact avec la couche semi-conductrice à oxyde à motif (103).

6. Procédé selon la revendication 2, **caractérisé en ce que** la couche de grille isolante (104) comprend une troisième partie (1041) et une quatrième partie (1042), la quatrième partie (1042) étant adjacente à la troisième partie (1041), la troisième partie (1041) étant disposée à l'opposé de la couche de grille à motif (105), et la quatrième partie (1042) étant en contact avec la couche de nitrure de silicium.

7. Procédé selon la revendication 1, **caractérisé en ce que** le processus de disposer la source (107) et le drain (108) pour être en contact avec la partie de la couche semi-conductrice à oxyde à motif (103) présentent les caractéristiques de conducteur comprend :
disposer un trou de contact (1061) relié à la partie de la couche semi-conductrice à oxyde à motif (103) dans la couche diélectrique (106) ;
disposer la source (107) et le drain (108) pour être en contact avec la partie de la couche semi-conductrice à oxyde à motif (103) à travers le trou de contact (1061) dans la couche diélectrique (106).

8. Panneau d'affichage à diode électroluminescente organique, dans lequel le panneau d'affichage comprend :
un substrat (101) ;
une couche tampon (102) déposée sur le substrat (101) ;
une couche semi-conductrice à oxyde à motif (103), une couche de grille isolante (104) et une couche de grille à motif (105) empilées successivement sur la couche tampon (102), dans lequel une partie de la couche semi-conductrice à oxyde à motif (103) présente des caractéristiques de conducteur ;
une couche diélectrique (106) recouvrant la couche semi-conductrice à oxyde à motif (103), la couche de grille isolante (104) et la couche de grille à motif (105), la couche diélectrique (106) comprenant une couche de nitrure de silicium en contact avec la couche semi-conductrice à oxyde à motif (103) ; et
une source (107) et un drain (108) en contact avec la partie de la couche semi-conductrice à oxyde à motif (103) présentent les caractéristiques de conducteur ;
**caractérisé en ce que**,
deux côtés opposés de la couche de grille isolante (104) s'étendent au-delà de la couche de grille à motif (105) pour présenter une longueur de parties étendues comprise entre 0,3 µm et 1 µm, et une épaisseur de la couche de grille isolante (104) est uniforme ;
dans lequel le panneau d'affichage comprend en outre :
une couche plane (109) et une couche de définition de pixels (110) empilées successivement sur la couche diélectrique (106) ; et
une couche d'anode (1111), une couche de transfert d'électrons (1112), une couche lumineuse (1113), une couche de transfert de trous (1114) et une couche de cathode (1115) disposées successivement à une position à l'opposé d'une région lumineuse de pixels sur la couche de définition de pixels (110).

9. Panneau d'affichage selon la revendication 8, **caractérisé en ce que** la couche semi-conductrice à oxyde à motif (103) comprend une première partie (1031) et une deuxième partie (1032), la deuxième partie (1032) étant adjacente à la première partie (1031), la première partie (1031) étant disposée à l'opposé de la couche de grille isolante (104), et la deuxième partie (1032) étant en contact avec la couche de nitrure de silicium pour présenter les caractéristiques de conducteur.

10. Panneau d'affichage selon la revendication 9, **caractérisé en ce que** la couche de nitrure de silicium contient des atomes d'hydrogène, pendant le processus de fabrication, les atomes d'hydrogène dans la couche de nitrure de silicium se diffusent vers la couche semi-conductrice à oxyde à motif (103) pour permettre à la deuxième partie (1032) d'être en contact avec la couche de nitrure de silicium et d'être dopée des atomes d'hydrogène pour présenter les caractéristiques de conducteur.
